Europäisches Patentamt

European Patent Office

Office européen des brevets

(19)

(11) EP 0 808 538 B1

(12) FASCICULE DE BREVET EUROPEEN

(45) Date de publication et mention
de la délivrance du brevet:
**15.05.2002 Bulletin 2002/20**

(21) Numéro de dépôt: **96903060.0**

(22) Date de dépôt: **06.02.1996**

(51) Int Cl.$^7$: **H04L 25/03**

(86) Numéro de dépôt international:
**PCT/FR96/00197**

(87) Numéro de publication internationale:
**WO 96/24999 (15.08.1996 Gazette 1996/37)**

(54) **DISPOSITIF DE RECEPTION DE SIGNAUX NUMERIQUES A STRUCTURE ITERATIVE, MODULE ET PROCEDE CORRESPONDANTS**

VERFAHREN, MODUL UND VORRICHTUNG ZUM EMPFANG DIGITALER SIGNALE MIT ITERATIVER ARBEITSWEISE

ITERATIVE-STRUCTURE DIGITAL SIGNAL RECEPTION DEVICE, AND MODULE AND METHOD THEREFOR

(84) Etats contractants désignés:
**DE FR GB IT**

(30) Priorité: **07.02.1995 FR 9501603**

(43) Date de publication de la demande:
**26.11.1997 Bulletin 1997/48**

(73) Titulaires:
  • **FRANCE TELECOM**
    **75015 Paris (FR)**
  • **TELEDIFFUSION DE FRANCE**
    **75732 Paris Cédex 15 (FR)**

(72) Inventeurs:
  • **DOUILLARD, Catherine**
    **F-29200 Brest (FR)**
  • **GLAVIEUX, Alain**
    **F-29285 Brest Cédex (FR)**
  • **JEZEQUEL, Michel**
    **F-29200 Brest (FR)**
  • **BERROU, Claude**
    **F-29280 Locamaria-Plouzane (FR)**

(74) Mandataire: **Vidon, Patrice**
    **Cabinet Patrice Vidon**
    **Le Nobel (Bât. A)**
    **Technopôle Atalante**
    **2, allée Antoine Becquerel**
    **BP 90333**
    **35703 Rennes Cedex 7 (FR)**

(56) Documents cités:
    **EP-A- 0 511 141          EP-A- 0 524 597**
    **WO-A-91/06165**

    • **ICC '93 GENEVA. IEEE INTERNATIONAL ICC '93 GENEVA. IEEE INTERNATIONAL CONFERENCE ON COMMUNICATIONS '93. CONFERENCE ON COMMUNICATIONS '93. TECHNICAL PROGRAM, CONFERENCE RECORD (CAT. TECHNICAL PROGRAM, CONFERENCE RECORD (CAT. NO.93CH3261-5), PROCEEDINGS OF ICC '93 - NO.93CH3261-5), PROCEEDINGS OF ICC '93 - IEEE INTERNATIONAL CONFERENCE ON IEEE INTERNATIONAL CONFERENCE ON COMMUNICATIONS, GENEVA, SWITZERLAND, 23-26 COMMUNICATIONS, GENEVA, SWITZERLAND, 23-26 MAY 1993, ISBN 0-7803-0950-2, 1993, NEW MAY 1993, ISBN 0-7803-0950-2, 1993, NEW YORK, NY, USA, IEEE, USA, YORK, NY, USA, IEEE, USA, pages 1064-1070 vol.237, XP000371240 pages 1064-1070 vol.237, XP000371240 BERROU C ET AL: "Near Shannon limit BERROU C ET AL: "Near Shannon limit error-correcting coding and decoding: error-correcting coding and decoding: Turbo-codes. 1" Turbo-codes. 1" cité dans la demande cité dans la demande**

- ELECTRONICS AND COMMUNICATIONS IN JAPAN, ELECTRONICS AND COMMUNICATIONS IN JAPAN, PART 1 (COMMUNICATIONS), APRIL 1994, USA, PART 1 (COMMUNICATIONS), APRIL 1994, USA, vol. 77, no. 4, ISSN 8756-6621, vol. 77, no. 4, ISSN 8756-6621, pages 103-110, XP000445333 pages 103-110, XP000445333 MURATA H ET AL: "Performance of adaptive MURATA H ET AL: "Performance of adaptive equalizer using iterative application of equalizer using iterative application of Viterbi algorithm" Viterbi algorithm"
- PHILIPS JOURNAL OF RESEARCH, 1987, PHILIPS JOURNAL OF RESEARCH, 1987, NETHERLANDS, NETHERLANDS, vol. 42, no. 4, ISSN 0165-5817, vol. 42, no. 4, ISSN 0165-5817, pages 399-428, XP000565157 pages 399-428, XP000565157 BERGMANS J W M ET AL: "On the use of BERGMANS J W M ET AL: "On the use of decision feedback for simplifying the decision feedback for simplifying the Viterbi detector" Viterbi detector"
- IEEE IN HOUSTON. GLOBECOM '93. IEEE GLOBAL IEEE IN HOUSTON. GLOBECOM '93. IEEE GLOBAL TELECOMMUNICATIONS CONFERENCE, INCLUDING A TELECOMMUNICATIONS CONFERENCE, INCLUDING A COMMUNICATIONS THEORY MINI-CONFERENCE. COMMUNICATIONS THEORY MINI-CONFERENCE. TECHNICAL PROGRAM CONFERENCE RECORD (CAT. TECHNICAL PROGRAM CONFERENCE RECORD (CAT. NO.93CH3250-8), PROCEEDINGS OF GLOBECOM NO.93CH3250-8), PROCEEDINGS OF GLOBECOM '93. IEEE GLOBAL TELECOMMUNICATIONS '93. IEEE GLOBAL TELECOMMUNICATIONS CONFERE, ISBN 0-7803-0917-0, 1993, NEW CONFERE, ISBN 0-7803-0917-0, 1993, NEW YORK, NY, USA, IEEE, USA, YORK, NY, USA, IEEE, USA, pages 98-102 vol.1, XP000428037 pages 98-102 vol.1, XP000428037 JIANJUN WU ET AL: "A channel model and a JIANJUN WU ET AL: "A channel model and a novel adaptive equalizer for mobile radio novel adaptive equalizer for mobile radio communications" communications"
- VEHICULAR TECHNOLOGY SOCIETY 42ND VTS VEHICULAR TECHNOLOGY SOCIETY 42ND VTS CONFERENCE. FRONTIERS OF TECHNOLOGY. FROM CONFERENCE. FRONTIERS OF TECHNOLOGY. FROM PIONEERS TO THE 21ST CENTURY (CAT. PIONEERS TO THE 21ST CENTURY (CAT. NO.92CH3159-1), DENVER, CO, USA, 10-13 MAY NO.92CH3159-1), DENVER, CO, USA, 10-13 MAY 1992, ISBN 0-7803-0673-2, 1992, NEW YORK, 1992, ISBN 0-7803-0673-2, 1992, NEW YORK, NY, USA, IEEE, USA, NY, USA, IEEE, USA, pages 577-585 vol.2, XP000339855 pages 577-585 vol.2, XP000339855 JUNG P ET AL: "VLSI implementation of JUNG P ET AL: "VLSI implementation of soft output Viterbi equalizers for mobile soft output Viterbi equalizers for mobile radio applications" radio applications" cité dans la demande cité dans la demande
- ICC '93 GENEVA. IEEE INTERNATIONAL ICC '93 GENEVA. IEEE INTERNATIONAL CONFERENCE ON COMMUNICATIONS '93. TECHNICAL CONFERENCE ON COMMUNICATIONS '93. TECHNICAL PROGRAM, CONFERENCE RECORD (CAT. PROGRAM, CONFERENCE RECORD (CAT. NO.93CH3261-5), PROCEEDINGS OF ICC '93 - NO.93CH3261-5), PROCEEDINGS OF ICC '93 - IEEE INTERNATIONAL CONFERENCE ON IEEE INTERNATIONAL CONFERENCE ON COMMUNICATIONS, GENEVA, SWITZERLAND, 23-26 COMMUNICATIONS, GENEVA, SWITZERLAND, 23-26 MAY 1993, ISBN 0-7803-0950-2, 1993, NEW MAY 1993, ISBN 0-7803-0950-2, 1993, NEW YORK, NY, USA, IEEE, USA, pages 1064-1070 YORK, NY, USA, IEEE, USA, pages 1064-1070 vol.237, XP000371240 BERROU C ET AL: "Near vol.237, XP000371240 BERROU C ET AL: "Near Shannon limit error-correcting coding and Shannon limit error-correcting coding and decoding: Turbo-codes. 1" decoding: Turbo-codes. 1"
- VEHICULAR TECHNOLOGY SOCIETY 42ND VTS VEHICULAR TECHNOLOGY SOCIETY 42ND VTS CONFERENCE. FRONTIERS OF TECHNOLOGY. FROM CONFERENCE. FRONTIERS OF TECHNOLOGY. FROM PIONEERS TO THE 21ST CENTURY (CAT. PIONEERS TO THE 21ST CENTURY (CAT. NO.92CH3159-1), DENVER, CO, USA, 10-13 MAY NO.92CH3159-1), DENVER, CO, USA, 10-13 MAY 1992, ISBN 0-7803-0673-2, 1992, NEW YORK, 1992, ISBN 0-7803-0673-2, 1992, NEW YORK, NY, USA, IEEE, USA, pages 577-585 vol.2, NY, USA, IEEE, USA, pages 577-585 vol.2, XP000339855 JUNG P ET AL: "VLSI XP000339855 JUNG P ET AL: "VLSI implementation of soft output Viterbi implementation of soft output Viterbi equalizers for mobile radio applications" equalizers for mobile radio applications"

**Description**

Le domaine de l'invention est celui de la transmission et de la diffusion de signaux numériques, en particulier en présence de bruits de transmission. Plus précisément, l'invention concerne la réception de signaux numériques codés à l'aide d'un code correcteur d'erreurs de type convolutif.

L'invention trouve des applications dans tous les cas où un signal numérique est transmis ou diffusé sur des canaux bruités. A titre d'exemple, la présente invention peut être mise en oeuvre dans les récepteurs de systèmes de radio-communications numériques avec les mobiles, tels que le GSM (Groupe Spécial Mobile).

D'autres applications possibles sont, par exemple, la réception de signaux transmis par faisceaux hertziens, par satellites... Plus généralement, l'invention s'applique avantageusement dans tous les cas où un code de type convolutif est mis en oeuvre à l'émission.

Dans les récepteurs de type connu, les symboles récupérés en sortie du démodulateur se présentent sous forme d'échantillons analogiques qui, après quantification, sont généralement traités par un égaliseur (filtre transversal) chargé d'éliminer l'interférence entre symboles introduite par le canal. Les échantillons égalisés sont ensuite désentrelacés, si nécessaire, et décodés avant d'être fournis au destinataire.

Le principe de l'égalisation consiste à estimer la réponse du canal de transmission pour appliquer au signal reçu un filtrage symétrique à cette réponse, de façon à obtenir un signal corrigé. Notamment, l'égalisation a pour but de supprimer, ou tout au moins de limiter l'interférence entre symboles introduite par le canal.

L'estimation de la réponse du canal se fait généralement par l'analyse d'un signal de référence connu des récepteurs. Bien sûr, la transmission de ces signaux de référence entraîne une réduction du débit utile.

Les éléments de données égalisés sont ensuite désentrelacés (opération symétrique à l'entrelacement effectué au codage, si un tel entrelacement est prévu), puis décodés.

Dans certaines situations, l'égalisation de ce type s'avère insuffisante pour assurer un décodage source de bonne qualité.

L'article "VLSI implementation of soft output Viterbi equalizers for mobile radio applications" (Proc. of IEEE 42$^{nd}$ Vehicular Technology Society Conference, Denver, Colorado, pp. 577-585, May 1992) de P. Jung et P. W. Baier propose d'utiliser, à la place d'un filtre transverse, un détecteur de symboles fonctionnant suivant le principe du maximum de vraisemblance.

Cette technique est plus performante, si les coefficients représentatifs du canal sont correctement estimés. Toutefois, à nouveau, les données égalisées peuvent s'avérer de qualité insuffisante. Par ailleurs, elle est de réalisation plus complexe et d'un encombrement plus important que la technique à filtre transverse.

Les codes convolutifs sont des codes associant à chaque donnée source à coder au moins une donnée codée, obtenue par sommation modulo 2 de cette donnée source avec au moins une des données source précédentes. Ainsi, chaque symbole codé est une combinaison linéaire de la donnée source à coder et des données sources précédentes prises en compte.

Dans le décodeur, les données d'origine sont le plus souvent reconstruites à l'aide d'un algorithme à maximum de vraisemblance, et par exemple l'algorithme de Viterbi, dont les décisions peuvent éventuellement être pondérées. L'algorithme de Viterbi, en prenant en compte une séquence de symboles codés reçus, fournit une estimation de chaque donnée codée à l'émission, en déterminant la séquence source correspondant le plus probablement à la séquence reçue.

L'algorithme de Viterbi peut également être utilisé pour la détection de séquences affectées d'interférences entre symboles. L'invention s'applique également dans ce cas.

Clairement, la décision est d'autant plus fiable que le nombre de symboles pris en compte est élevé. En revanche, plus ce nombre est élevé, plus le décodeur, ou le détecteur (dans la suite, on utilise le terme "décodeur" pour décrire aussi bien les décodeurs au sens propre que les détecteurs. Il en est de même pour le terme "décodage", qui doit être compris comme "décodage" ou "détection", selon le cas), est complexe. La place mémoire nécessaire devient rapidement très importante, de même que les temps de calcul correspondants.

Les circuits intégrés mettant en oeuvre de tels algorithmes reposent donc le plus souvent sur un compromis entre le coût et les performances. Ces choix industriels ne permettent pas toujours de construire des décodeurs correspondant de façon optimum à une application donnée. Il n'est par exemple pas possible de réaliser de décodeurs à faible prix de revient, pour des applications où la qualité de réception n'est pas cruciale, les circuits intégrés ayant un coût trop élevé. Inversement, ces circuits intégrés ne sont pas non plus adaptés à la réalisation de récepteurs à très haute qualité de décodage, pour lesquels le prix de revient n'a que peu d'importance.

Un exemple de codage convolutif avantageux, auquel peut s'appliquer l'invention, est décrit dans la demande de brevet française FR-A-2 675 970 au nom des mêmes déposants, ainsi que dans l'article "de C. Berrou, A. Glavieux et P. Thitimajshima, "Near Shannon limit error-correcting coding and decoding : turbo-codes" (codage et décodage et décodage correcteurs d'erreurs à proximité de la limite de Shannon) (Proc. ICC'93, pp. 1064-1070, Genève, Suisse, Mai 1993). Cette classe de codes est notamment connue sous le nom de "turbo-codes".

Les codes élémentaires (codes systématiques récursifs ou pseudo-systématiques) décrits dans la demande de brevet EP-A-0 511 141 au nom des mêmes déposants peuvent également être utilisés.

L'invention a notamment pour but de pallier les inconvénients des dispositifs de réception de l'art antérieur, et plus précisément d'améliorer les performances correspondantes.

Plus précisément, un objectif de l'invention est de fournir un tel dispositif présentant un très bon pouvoir de correction, en comparaison avec les procédés connus utilisés actuellement dans les systèmes de communications numériques.

L'invention a notamment pour objectif de fournir de tels procédés, particulièrement efficaces, toujours par rapport aux procédés connus, pour la transmission dans des canaux très bruités.

L'invention a également pour objectif de fournir un tel dispositif, qui soit très performant, mais malgré tout aisément réalisable industriellement à des coûts acceptables.

Ainsi, un objectif particulier de l'invention est de fournir un procédé de décodage permettant une implantation sur une surface de silicium suffisamment restreinte pour que son industrialisation soit possible, et par exemple sur une surface inférieure à 50 mm$^2$.

L'invention a également pour objectif de fournir un procédé de réception permettant la réalisation de nombreux types de récepteurs, à performances et prix de revient variables en fonction des besoins auxquels ils répondent, et mettant en oeuvre un ou plusieurs circuits intégrés d'un type unique.

En d'autres termes, un objectif essentiel de l'invention est de fournir de tels procédés permettant d'une part une industrialisation rentable, basée sur le développement d'un circuit intégré unique et relativement simple, et d'autre part la réalisation de récepteurs utilisables pour une très grande diversité d'applications.

Ces objectifs, ainsi que d'autres qui apparaîtront par la suite, sont atteints selon l'invention à l'aide d'un dispositif de réception de signaux formés d'une série de symboles numériques correspondant au codage convolutif de données numériques source, comprenant p modules de détection et de décodage $M_1$ à $M_p$ en cascade, p étant supérieur ou égal à 2,

chacun desdits modules $M_i$ comprenant :

des moyens de correction de l'interférence entre symboles, alimentés par une entrée de symbole $R_1$ et délivrant des symboles estimés $A_{i,1}$ à valeurs pondérées,

des moyens de décodage desdits symboles estimés $A_{i,1}$, effectuant des opérations symétriques audit codage convolutif et délivrant des symboles décodés $A_{i,2}$ à valeurs pondérées, et

des moyens de calcul d'une information de correction $Z_{i+1}$ à partir dudit symbole estimé $A_{i,1}$ et dudit symbole décodé $A_{i,2}$,

lesdits moyens de correction de chacun desdits modules $M_i$, à l'exception du premier module $M_1$, tenant compte d'au moins une information de correction $Z_i$ déterminée par le module précédent $M_{i-1}$.

Ainsi, selon l'invention, la fonction classique d'égalisation (filtrage) est remplacée par un détecteur de symboles, qui tient compte de l'effet de mémoire introduit par le canal.

En d'autres termes, l'invention propose une approche tout à fait nouvelle et optimisée de la correction de l'interférence entre symboles. En effet, classiquement, l'égalisation ne tient pas compte des données émises, mais seulement de l'estimation du canal. En revanche, l'invention s'appuie sur une approche dynamique, en tenant compte des derniers symboles reçus pour améliorer l'égalisation.

En d'autres termes encore, l'invention assimile, dans son principe général, l'effet des interférences entre symboles à un codage convolutif particulier (à l'exception de l'absence de redondance, dans le cas de l'interférence : à un symbole émis sur le canal correspond un symbole reçu et un seul), et en assure le décodage. Plus précisément, le phénomène d'interférence entre symboles introduit par le canal peut être représenté par un treillis. Ce treillis diffère d'un treillis de codage convolutif par la présence de coefficients multiplicatifs variant dans le temps. Ainsi, chaque module de l'invention comprend des moyens de correction et des moyens de décodage présentant des structures similaires à base de techniques de décodage convolutif.

La technique de l'invention consiste donc à calculer une information de correction représentative du symbole reçu, et à prendre en compte une ou plusieurs de ces informations, pour corriger l'interférence.

On comprend que la prise en compte de cette information impose une structure itérative de réception du fait de la latence introduite par les traitements. Ainsi, lors de la première itération, on calcule une première information de correction, qui est utilisée et éventuellement recalculée lors des itérations suivantes. Selon l'invention, cette approche itérative se traduit par une structuration en modules cascadés du récepteur (détecteur de symboles et décodeur), chaque module correspondant à une itération. Il s'agit d'une approche tout à fait nouvelle, en ce qui concerne la correction de l'interférence entre symboles.

Avantageusement, ces modules sont tous identiques. Ils peuvent notamment se présenter sous la forme de circuits intégrés.

Plus le nombre de modules est grand, plus l'efficacité de la réception (correction de l'interférence entre symboles et décodage) augmente. L'approche modulaire de l'invention permet de réaliser aisément plusieurs types de récepteurs, correspondant à différents niveaux de qualité de réception, en fonction du nombre de modules mis en oeuvre. De même, il est possible de prévoir des décodeurs évolutifs, auxquels on peut ajouter des modules en cas de besoin.

Selon un mode de réalisation préférentiel de l'invention, chacun desdits modules $M_i$ présente deux entrées, une entrée de symbole $R_i$ et une entrée de correction $Z_i$, et trois sorties, une sortie de symbole $R_{i+1}$, une sortie de correction $Z_{i+1}$ et une sortie de symbole décodé $D_{i+1}$,

l'entrée de symbole $R_i$ du module $M_i$ étant connectée à la sortie de symbole $R_i$ du module $M_{i-1}$, pour i supérieur à 1, et étant alimenté par les symboles reçus pour i égal à 1,

l'entrée de correction $Z_i$ du module $M_i$ étant connectée à la sortie de correction $Z_i$ du module $M_{i-1}$, pour i supérieur à 1, et étant alimenté par une valeur neutre, n'influant par sur la correction, pour i égal à 1,

la sortie de symbole $R_{i+1}$ du module $M_i$ étant égale à l'entrée de symbole $R_i$ dudit module $M_1$ retardée du temps de latence imposé par le module $M_i$,

la sortie de correction $Z_{i+1}$ délivrant ladite information de correction, et

la sortie de symbole décodé $D_{i+1}$ étant inutilisée pour les modules $M_1$ à $M_{p-1}$, et étant alimentée par le symbole décodé $A_{p,2}$ du module $M_p$, si le code mis en-oeuvre est un code systématique, et par une valeur reconstituée correspondante sinon.

Cette structure permet de concevoir, comme indiqué plus haut, des modules identiques. Bien sûr, suivant qu'il s'agit du premier module, du dernier module ou d'un module intermédiaire, les entrées et sorties utilisées peuvent être différentes.

Avantageusement, lesdits moyens de correction de l'interférence entre symboles sont alimentés par une information de correction $Z_i$ représentative d'une différence entre chaque symbole décodé $A_{i,2}$ et le symbole estimé $A_{i,1}$ correspondant.

Dans ce cas, préférentiellement, lesdits moyens de calcul de l'information de correction comprennent des moyens de multiplication desdits symboles estimés $A_{i,1}$ par un coefficient pondérateur positif $\gamma_2$, délivrant des symboles pondérés, et des moyens de soustraction calculant la différence entre chaque symbole décodé $A_{i,2}$ et le symbole pondéré correspondant, et délivrant ladite information de correction $Z_i$.

Notamment, la valeur de ce coefficient est fixée de telle façon que l'information portée par $Z_i$ ne contienne plus d'information concernant $A_{i,1}$, afin que les bruits affectant $Z_i$ et les échantillons reçus $R_i$ soient décorrélés. Ainsi, l'information réinjectée en entrée de l'égaliseur est "nouvelle" par rapport aux échantillons reçus (elle est issue du processus de décodage). Elle sera dite "information extrinsèque".

Selon un mode de réalisation avantageux, lesdits moyens de correction de l'interférence entre symboles effectuent les opérations suivantes:

- calcul d'une valeur de correction $V_i = \gamma_1|Z_i|$, où $\gamma_1$ est un coefficient positif et où 11 représente l'opérateur valeur absolue ;
- pour chaque branche du treillis correspondant audit code convolutif, détermination d'un symbole détecté $A_{i,0}$, comprenant les étapes suivantes :

  - si le symbole affecté à ladite branche est de même signe que ladite information de correction $Z_i$, soustraction à la métrique associée à ladite branche de ladite valeur de correction $V_i$ ;
  - si le symbole affecté à ladite branche est de signe opposé à celui de ladite information de correction $Z_i$, addition à la métrique associée à ladite branche de ladite valeur de correction $V_i$ ;

- soustraction audit symbole détecté $A_{i,0}$ de la valeur $\gamma_1 Z_i$.

Cette dernière soustraction a pour objet de "débarrasser" la sortie du détecteur de symboles, et donc a fortiori l'entrée du décodeur convolutif, de l'information portée par $Z_i$.

La pondération des symboles émis sur le canal a pour but, classiquement, de représenter l'interférence entre symboles. Les coefficients de pondération peuvent être fixes ou, préférentiellement, estimés, par exemple à l'aide d'une séquence d'apprentissage.

De façon préférentielle, ledit coefficient $\gamma_1$ dépend d'au moins une des informations appartenant au groupe comprenant :

- le rapport signal à bruit ;
- le numéro i du module considéré.

On comprend en effet que, plus $\gamma_1$ est grand, plus la sortie du décodeur est fiable.

Lorsque les symboles sont soumis à un entrelacement à l'émission, le décodeur comprend préférentiellement :

- des moyens de désentrelacement assurant l'opération symétrique dudit entrelacement, insérés entre lesdits moyens de correction et lesdits moyens de décodage ; et
- des moyens d'entrelacement assurant un entrelacement desdites informations de correction identique audit entrelacement à l'émission.

L'entrelacement et le désentrelacement peuvent être réalisés à l'aide de matrices.

Les incréments de lecture ou d'écriture peuvent être fixes ou, plus avantageusement, peuvent dépendre de l'adresse de lecture ou d'écriture.

L'invention concerne également un module de détection et de décodage destiné à être mis en oeuvre dans un dispositif de réception de signaux formés d'une série de symboles numériques correspondant au codage convolutif de données numériques source, ledit dispositif comprenant au moins deux modules en cascade, module présentant deux entrées, une entrée de symbole $R_i$ et une entrée de correction $Z_i$, et trois sorties, une sortie de symbole $R_{i+1}$, une sortie de correction $Z_{i+1}$ et une sortie de symbole décodé $D_{i+1}$, et comprenant :

des moyens de correction de l'interférence entre symboles, alimentés par ladite entrée de symbole $R_i$ et tenant compte de ladite entrée de correction $Z_i$, et délivrant des symboles estimés $A_{i,1}$,
des moyens de décodage desdits symboles estimés $A_{i,1}$, effectuant des opérations symétriques audit codage convolutif et délivrant des symboles décodés $A_{i,2}$, et des moyens de calcul d'une information de correction $Z_{i+1}$ à partir dudit symbole estimé $A_{i,1}$ et dudit symbole décodé $A_{i,2}$,

la sortie de symbole $R_{i+1}$ étant égale à l'entrée de symbole $R_i$ retardée d'un temps de latence prédéfini,
la sortie de correction $Z_{i+1}$ délivrant ladite information de correction, et
la sortie de symbole décodé $D_{i+1}$ étant alimentée par ledit symbole décodé $A_{i,2}$, ou par une valeur reconstituée en fonction du code mis en oeuvre.

Comme indiqué précédemment, un tel module peut notamment se présenter sous la forme d'un circuit intégré.

L'invention concerne encore un procédé de réception de signaux formés d'une série de symboles numériques correspondant au codage convolutif de données numériques source, comprenant les étapes suivantes :

- alimentation par des symboles reçus $R_i$ ;
- correction de l'interférence entre symboles affectant chacun desdits symboles reçus à partir d'une information de correction $Z_i$, et délivrant des symboles estimés $A_{i,1}$ ;
- décodage desdits symboles estimés $A_{i,1}$, effectuant des opérations symétriques audit codage convolutif et délivrant des symboles décodés $A_{i,2}$;
- calcul de ladite information de correction $Z_i$, à partir et d'au moins un desdits symboles estimés $A_{i,1}$ et d'au moins un desdits symboles décodés $A_{i,2}$.

D'autres caractéristiques et avantages de l'invention apparaîtront à la lecture de la description suivante d'un mode de réalisation préférentiel de l'invention donné à titre illustratif et non limitatif, et des dessins annexés, dans lesquels :

- la figure 1 est un schéma synoptique illustrant une chaîne de transmission classique, pouvant incorporer un dispositif de réception selon l'invention ;
- la figure 2 représente de façon simplifiée un modèle discret équivalent en bande de base d'un canal de transmission affectée d'une interférence entre symboles, illustrant l'approche de l'invention ;
- la figure 3 représente le treillis correspondant au canal de la figure 2 et illustrant les évolutions possibles de l'état du canal en fonction du temps ;
- la figure 4 est un schéma synoptique de principe du récepteur de l'invention ;
- la figure 5 est un organigramme simplifié illustrant le procédé de l'invention, mis en oeuvre dans le récepteur de la figure 4 ;
- la figure 6 illustre la structure modulaire du récepteur de l'invention, dans le cas de quatre modules cascadés ;
- la figure 7 présente un schéma synoptique d'un module de la figure 6 ;
- la figure 8 présente une série de courbes illustrant les performances de l'invention, dans le cas d'un canal gaussien.

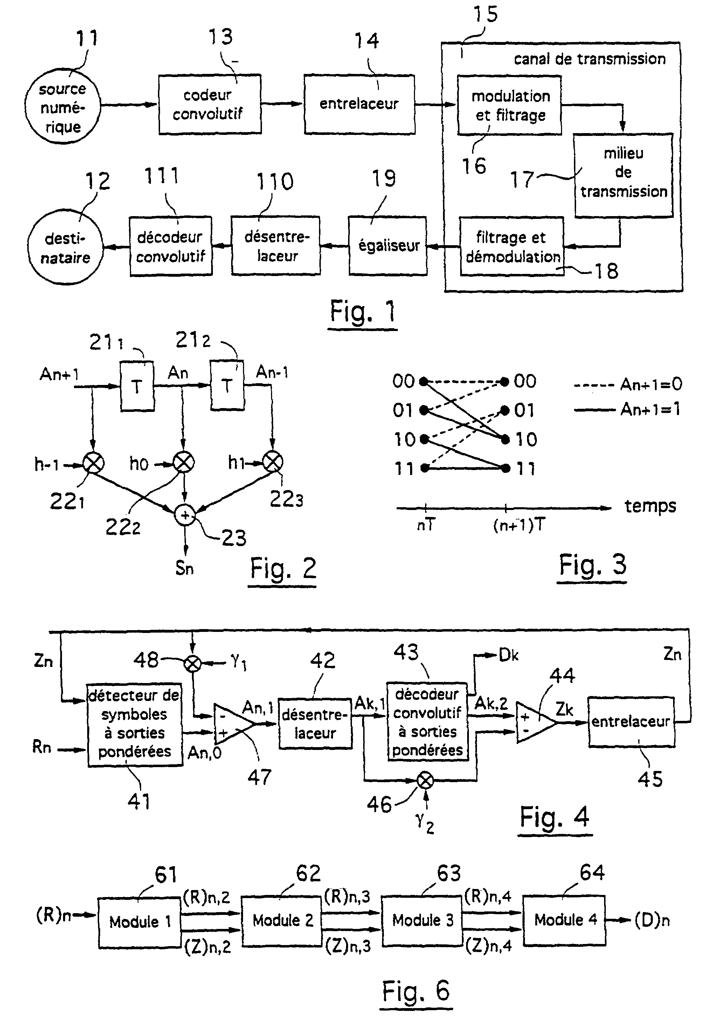

L'invention s'applique, comme indiqué précédemment, à tous les systèmes de transmission numérique mettant en oeuvre un codage correcteur d'erreur convolutif, tels qu'illustrés en figure 1.

Ce système comprend une source numérique Il qui doit être transmise à un destinataire 12.

Par source numérique, on entend tout signal numérique utile (son, image, données) et, plus généralement tout ensemble de signaux utiles, par exemple multiplexés en temps et/ou en fréquence. Le destinataire 12 peut être unique (cas de la transmission) ou multiple (cas de la diffusion). De même, la chaîne de transmission peut bien sûr être unidirectionnelle (radiodiffusion par exemple) ou bidirectionnelle (radiocommunication par exemple).

Le signal source est tout d'abord soumis à un codage convolutif 13 de type connu en soi. Il peut notamment d'agir d'un codage convolutif systématique-classique, associant à chaque donnée source au moins une valeur déterminée par combinaison de cette donnée et d'au moins une des données source précédentes.

Il peut également s'agir d'un code tels que ceux décrits dans la demande de brevet FR-A- 2 675 970. Ces codes, dits "pseudo-systématiques", sont caractérisés par le fait que la donnée source est systématiquement transmise, conjointement à au moins une donnée codée, ou symbole de redondance.

Tout autre code convolutif peut également être utilisé.

Les données délivrées par le codeur 13 sont ensuite avantageusement (bien qu'il ne s'agisse pas d'une caractéristique obligatoire) soumis à un entrelacement 14.

Cet entrelacement peut être obtenu, de façon classique, à l'aide d'une matrice d'entrelacement, dans laquelle les données source sont introduites ligne par ligne, et restituées colonne par colonne.

Le module 14 assure un entrelacement matriciel. Les données sont écrites, par lignes successives, dans une mémoire de taille $n_E \times n_E$, et restituées par colonnes successives. Cette technique est par exemple décrite dans l'article "Optimal interleaving scheme for convolutional coding (Méthode d'entrelacement optimal pour le codage convolutif), de Dunscombe E. et Piper F.C., paru dans l'"Electronic Letters", Vol.25, n°22, Octobre 1989.

Ainsi que le montre cet article, l'efficacité de l'entrelacement, pour de petites valeurs de $n_E$ (quelques dizaines) est améliorée si la succession de lignes et de colonnes s'effectue selon un incrément supérieur à 1 et, par nécessité, premier avec $n_E$.

Une amélioration complémentaire à cette technique d'entrelacement peut être mise en oeuvre. Il apparaît en effet avantageux que l'incrément du saut de ligne, toujours premier avec $n_E$, soit fonction de la place de la colonne considérée. Cela permet de casser les paquets d'erreurs à disposition rectangulaire.

Dans ce cas, les incréments de lecture de la matrice d'entrelacement sont choisis de telle sorte que la distance minimale, en sortie, entre deux symboles voisins à l'entrée soit la plus grande possible. Ces incréments peuvent par exemple être déterminés de façon empirique.

D'autres techniques d'entrelacement peuvent bien sûr être utilisées, et notamment l'habituel procédé à incréments d'écriture et de lecture égaux à 1, sans sortir du cadre de l'invention. Il est clair par ailleurs que les rôles des lignes et des colonnes peuvent être inversés.

Ensuite, le signal entrelacé est transmis au travers du canal de transmission 15, il subit donc une modulation et un filtrage 16, selon toute technique adéquate, puis est émis au travers du milieu de transmission 17.

Ce milieu de transmission 17 est généralement bruité et présente de l'interférence entre les symboles émis dans celui-ci.

Il est à noter que, selon l'invention, les deux sources de perturbations que sont le bruit et l'interférence entre symboles (IES) sont considérées de façons dissociées. En d'autres termes, les symboles affectés d'IES sont de plus bruités. L'IES est principalement due à des distorsions introduites par les éléments de filtrage de la chaîne de transmission et la présence de trajets multiples induits par le milieu physique de transmission (due à des réflexions sur des obstacles, etc...). Ces phénomènes entraînent des perturbations entre les symboles. Le bruit induit par le milieu physique vient s'ajouter à ce phénomène d'IES et est susceptible de modifier de surcroît les informations portées par les symboles.

La figure 2 illustre cette approche dans le cas simplifié d'une interférence portant sur deux symboles.

On note $A_n$ le symbole émis à l'instant nT, où 1/T est la rapidité de modulation (T étant la durée d'un symbole). le signal reçu $S_n$ peut s'écrire, après passage dans le canal de transmission :

$$S_n = \Sigma_k h_k A_{n-k}$$

Ce signal comporte un terme dépendant du symbole $A_n$, à savoir $h_0 A_n$, mais également un terme dépendant des symboles émis antérieurement et postérieurement à $A_n$. Ce second terme est le terme d'interférence entre symboles. Il peut s'écrire sous la forme $\Sigma_{k \neq 0} h_k A_{n-k}$. Il est dû au filtrage introduit par le canal, et peut être modélisé par un treillis à $N = 2^\nu$ états, pour une IES modélisée par un canal discret équivalent de mémoire $\nu$ (2 dans le cas des figures 2 et 3).

Dans le cas de la figure 2, on considère une interférence portant sur deux symboles ($A_{n-1}$ et $A_{n+1}$). L'effet du

canal peut alors être représenté par deux cellules à retard $21_1$ et $21_2$, chacune d'une durée T.

Lorsqu'en entrée de la cellule $21_1$, est présenté le symbole $A_{n+1}$, la sortie de celle-ci est $A_n$, et la sortie de la seconde cellule $21_2$ est $A_{n-1}$. Le filtrage du canal revient à multiplier ($22_1$ à $22_3$) chacun de ces symboles par le coefficient de filtrage correspondant $h_i$. Les termes correspondants sont ensuite additionnés (23) pour former le signal $S_n$.

L'architecture de la figure 2 correspond à un codage convolutif avec $\nu = 2$, dont le treillis de décodage est illustré en figure 3. Classiquement, ce treillis illustre les transitions possibles en fonction des deux valeurs précédentes, selon que la valeur de $A_{n+1}$ est 1 (traits pleins) ou 0 (traits pointillés).

En revenant à la figure 1, le signal $S_n$ bruité est soumis à un filtrage et une démodulation 18, symétriques des opérations assurées par le module 16.

Ensuite, classiquement, le signal est égalisé (19), par application d'un filtrage visant à compenser les effets du milieu de transmission 17. Le signal égalisé est alors désentrelacé (110), symétriquement à l'entrelacement 14.

Enfin, le signal est transmis à un décodeur convolutif 111, qui met par exemple en oeuvre un décodage à maximum de vraisemblance, tel que l'algorithme de Viterbi, pour délivrer des données décodées au destinataire 12.

La caractéristique essentielle de l'invention est l'association itérative d'un module de détection de symboles à sorties pondérées et d'un module de décodage, également à sorties pondérées. En considérant l'effet du canal selon l'approche présentée, l'égalisation classique (filtrage du signal reçu, à l'aide d'un filtre transversal, par exemple) est remplacée par une détection de symbole tenant compte de l'effet de mémoire introduit par le canal.

Ainsi, le dispositif proposé inclut un détecteur à entrée et à sortie pondérées qui estime les symboles $A_n$ à partir de la sortie bruitée du canal. Ce détecteur peut, à titre d'exemple, être réalisé en utilisant l'algorithme décrit dans le document de brevet FR-A-2 675 968. Il nécessite la connaissance des coefficients $h_k$, qui devront donc être estimés de manière externe au dispositif proposé, par exemple à l'aide de séquences d'apprentissage.

La figure 4 illustre le principe général de l'invention.

Chaque échantillon $R_n$ reçu, qui correspond à la sortie bruitée du canal de transmission est traitée comme suit :

- un détecteur 41 de symboles à sorties pondérées produit une estimation $A_{n,1}$ du symbole émis correspondant ;
- les symboles $A_{n,1}$ en sortie du détecteur 41 sont désentrelacés (42) pour fournir les symboles $A_{k,1}$ ;
- les symboles désentrelacés $A_{k,1}$ sont présentés à l'entrée d'un décodeur convolutif 43 qui fournit une nouvelle estimation $A_{k,2}$ de symboles $A_k$ ;
- en sortie du décodeur 43, on détermine (44) une donnée de correction Zk, dite information extrinsèque obtenue à partir des estimations $A_{k,1}$ et $A_{k,2}$ ;
- la donnée de correction $Z_k$ est ensuite utilisée, après un réentrelacement 45, dans le détecteur 41.

Plus précisément, dans le mode de réalisation décrit, la donnée $Z_k$ est obtenue par différence entre $A_{k,2}$ et $\gamma_2 A_{k,1}$, délivré par le multiplicateur 46, ou $\gamma_2$ est un coefficient positif. $Z_n$ est encore une estimation du symbole $A_n$, mais cette fois affectée d'un bruit non corrélé avec celui qui affecte $A_{n,1}$ et faiblement corrélé avec celui affectant $R_n$, grâce à la fonction d'entrelacement 45.

L'information extrinsèque $Z_n$ est ensuite utilisée par le détecteur 41 en ajoutant ou en retranchant à chaque métrique de branche du treillis associé au canal (cf figure 3) le terme $\gamma_1 |Z_n|$, où $\gamma_1$ est un coefficient positif. Le terme $\gamma_1 |Z_n|$ est retranché (respectivement ajouté) lorsque le symbole affecté à la branche considérée est de même signe que $Z_n$ (respectivement de signe contraire). La valeur du coefficient $\gamma_1$ dépend à la fois du rapport signal à bruit et de la fiabilité de l'information extrinsèque $Z_n$.

L'information extrinsèque, affectée du coefficient $\gamma_1$ pour le multiplieur 48 est par ailleurs retranchée (47) à la sortie du détecteur 41 avant d'être présentée à l'entrée du décodeur 43. En effet, l'information extrinsèque $Z_n$ ayant été produite par le décodeur 43, elle ne doit pas être réutilisée par celui-ci.

Le détecteur de symboles 41 prend ses décisions suivant un algorithme de type Viterbi. Toutes les opérations effectuées par ce détecteur correspondent à celles décrites dans le brevet FR-A-2 675 968. La différence, par rapport à un algorithme de décodage convolutif, réside dans le calcul des métriques de transition, ou métriques de branche, qui est mené différemment.

Chaque noeud du treillis est représentatif d'un état possible du canal à un instant nT donné. Pour une IES portant sur K1 symboles postérieurs et K2 symboles antérieurs au symbole considéré, c'est-à-dire pour :

$$S_n = \Sigma_{k=-K1 \text{ à } K2} \, h_k A_{n-k}$$

l'état du canal à $t = nT$ est donné par le (K1+K2)-uplet $(A_{n+K1-1}...A_{n+1}A_n \, A_{n-1}...A_{n-K2})$. La connaissance de l'état du canal à $t = nT$ ainsi que de la valeur de $A_{n+K1}$ (symbole "entrant" dans le canal) permet alors de connaître son état à $t = (n+1)T$.

Ainsi, pour chaque noeud j du treillis pris à l'instant $t = nT$, deux métriques de transition $L_j^0$ et $L_j^1$ sont calculées.

Elles correspondent aux deux transitions possibles ($A_{n+K1}= 0$ et $A_{n+K1}= 1$). Elles sont de la forme :

$$L_j^0 = (R_n - R_j^0)^2 \text{ et } L_j^1 = (R_n - R_j^1)^2$$

où $R_n$ représente l'échantillon effectivement reçu en entrée du détecteur et $R_j^0$ (respectivement $R_j^1$) est la valeur théorique de l'échantillon non bruité lorsque l'état du canal correspond au noeud j du treillis et que $A_{n+K1}=0$ (respectivement $A_{n+K1}=1$). $R_j^0$ (respectivement $R_j^1$) est donc de la forme : $\Sigma_{k=-K1 \text{ à } K2} h_k A_{n-k}$. Si $A_{n+K1}= 0$, il s'agit de $R_j^0$, et si $A_{n+K1}=1$, il s'agit de $R_j^1$.

En pratique, on utilise l'expression simplifiée suivante pour le calcul des métriques :

$$L_j^0 = |R_n - R_j^0| \text{ et } L_j^1 = |R_n - R_j^1|$$

Les performances de la détection sont alors très proches de celles obtenues avec l'expression précédente, et l'implantation sur silicium du calcul est très simplifiée.

En dehors de ce calcul des métriques, l'algorithme de calcul est similaire, dans son principe comme dans sa mise en oeuvre, à un algorithme de décodage convolutif.

Dans la pratique, le récepteur illustré en figure 4 induit une latence de calcul (temps de traitement du détecteur 41, du décodeur 43, de l'entrelacement 45 et du désentrelacement 42). Il n'est donc pas possible de connaître instantanément $Z_n$ lorsqu'on reçoit $R_n$ dans le détecteur 41. En conséquence, selon une caractéristique essentielle de l'invention, le processus mis en oeuvre est itératif.

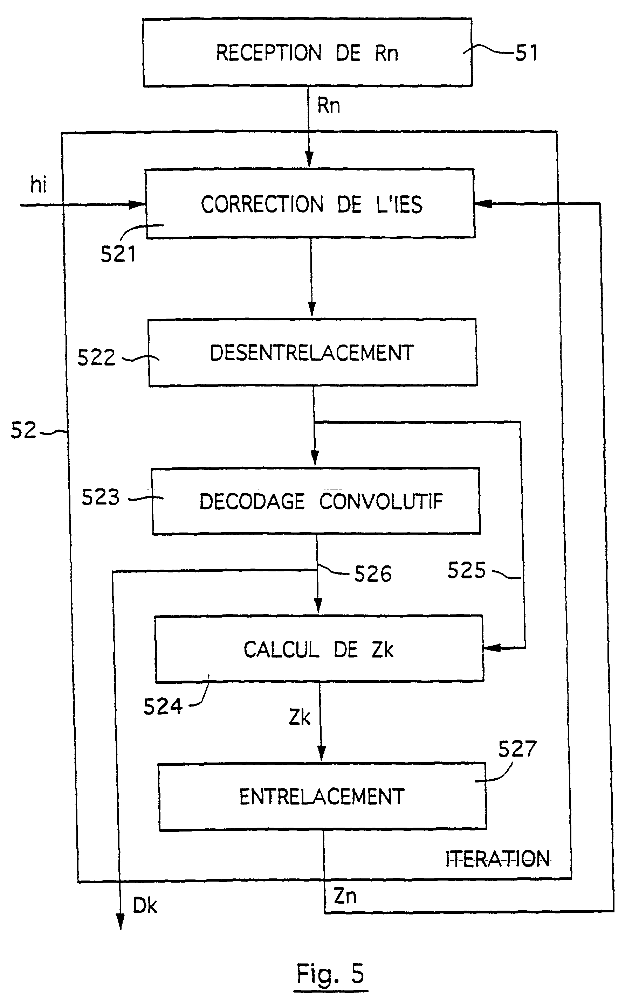

Ce processus est schématiquement illustré par la figure 5. Pour chaque symbole reçu $R_n$ (étape de réception 51), au moins deux itérations 52 sont effectuées.

Chaque itération 52 comprend une étape 521 de correction de l'interférence entre symboles. Comme indiqué précédemment, cette correction met en oeuvre une technique de décodage convolutif, et tient compte d'une information extrinsèque de correction $Z_n$ et de données $h_i$ représentatives du canal de transmission.

Les informations $Z_n$ sont calculées lors de l'étape 524. Bien sûr, lors de la première itération, aucune valeur particulière de $Z_n$ n'est connue. En conséquence, celle-ci est alors fixée à une valeur neutre, c'est-à-dire n'influant pas sur les calculs.

Après la correction 521, les symboles estimés sont désentrelacés lors de l'étape 522 de désentrelacement (si un entrelacement a été mis en oeuvre à l'émission), puis décodés, selon une technique classique de décodage convolutif 523, et par exemple selon la technique décrite dans la demande française FR-A-2 675 968.

Ensuite on calcule (524) l'information extrinsèque $Z_k$, à partir de la donnée 525 détectée par l'étape 521 de correction et de la donnée 526 décodée par l'étape 523 de décodage. Puis les informations $Z_k$ sont ré-entrelacées (527), symétriquement au désentrelacement 522, pour fournir les informations $Z_n$. L'information $Z_n$ est prise en compte dans l'étape de correction 521 de l'itération suivante.

Lors de la dernière itération, l'étape 524 de calcul de $Z_k$ n'est pas mise en oeuvre, Le symbole décodé $D_k$ est délivré par l'étape de décodage 523.

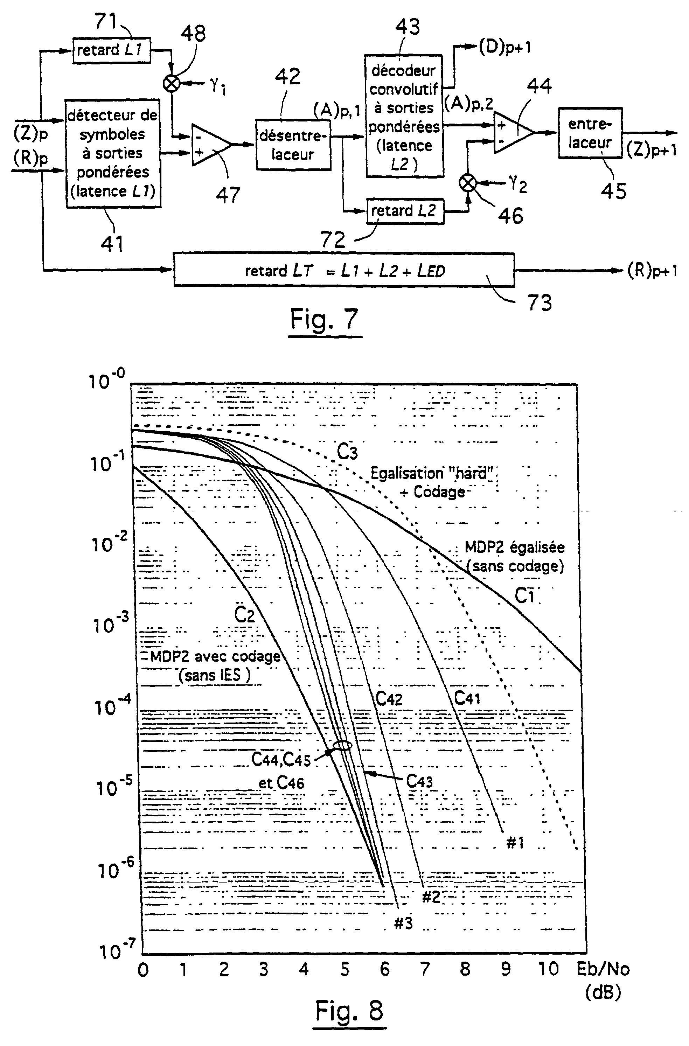

Le dispositif de réception correspondant peut avantageusement être réalisé de façon modulaire, en associant un module à chaque itération. La figure 6 illustre un tel dispositif, comprenant quatre modules.

Le premier module 61 de la chaîne reçoit $(R)_n$, le symbole reçu par le dispositif, et délivre d'une part $(R)_{n,2}$, qui est égal à $(R)_n$ affecté d'un retard correspondant à la latence du module, et d'autre part $(Z)_{n,2}$ l'information extrinsèque calculé par le module 61. Chacun des modules suivants 62 à 64 reçoit le symbole retardé $(R)_{n,i}$ et l'information extrinsèque $(Z)_{n,i}$. Le dernier module 64 délivre le symbole décodé $(D)_n$.

On comprend aisément que les performances du dispositif, en terme de taux d'erreur sont fonction du nombre de modules mis en cascade.

De façon avantageuse, tous les modules sont identiques. La figure 7 illustre un exemple de réalisation d'un tel module. Plus précisément, il s'agit du module correspondant à la p$^{\text{ième}}$ itération. Il comprend :

- 2 entrées : $(R)_p$ et $(Z)_p$,
- 3 sorties : $(R)_{p+1}$, $(Z)_{p+1}$ et $(D)_{p+1}$.

L'entrée $(R)_p$ est égale à la sortie du canal retardée de la latence de p-1 modules.

L'entrée $(Z)_p$ provient du module précédent et est fixée, pour p = 1, à une valeur neutre, c'est-à-dire n'influant pas sur la sortie du détecteur.

La sortie $(R)_{p+1}$, égale à l'entrée $(R)_p$ retardée de la latence d'un module, est inutilisée si l'itération est la dernière du processus (p=P, P étant le nombre total de modules).

La sortie $(Z)_{p+1}$ est l'information extrinsèque élaborée à la $p^{\text{ième}}$ itération. Cette sortie est également inutilisée dans le cas ou p = P.

La sortie $(D)_{p+1}$, qui est la donnée décodée, est inutilisée par les P - 1 premiers modules, seules les données issues de $(D)_{p+1}$ sont fournies au destinataire.

Les éléments de ce module déjà décrits en relation avec la figure 4 ne sont pas décrits à nouveau, et portent les mêmes références. On notera que, par rapport au schéma de principe de la figure 4, différents retards sont ajoutés, pour prendre en compte les latences des différents éléments.

Ainsi, l'information extrinsèque $(Z)_p$ utilisée pour la différence 47 doit être retardée (71) d'une durée égale à la latence $L_1$ du détecteur 41. C'est également le cas de $(A)_{p,1}$ qui doit être retardée de la latence $L_2$ du décodeur 43. Enfin, $(R)_p$ doit être retardée (73) de la latence totale introduite par un module, $L_T$, afin que $(R)_{p+1}$ et $(Z)_{p+1}$ soient présentées au même instant à l'entrée du module suivant. Cette latence $L_T$ est égale à la somme des latences'du détecteur 41, $L_1$, du décodeur, $L_2$, et de la latence introduite par les opérations d'entrelacement 45 et de désentrelacement 42 $L_{ED}$.

Les performances du dispositif de l'invention ont été simulées, et sont illustrées en figure 8. La donnée source est codée par un code convolutif systématique récursif (code CSR) de longueur de contrainte K = 5 et de rendement R = 1/2. Les données codées sont envoyées sur le canal de transmission après un entrelacement non uniforme dans une matrice de 64 lignes et 64 colonnes. La modulation utilisée est une modulation de phase à 2 états (MDP2).

Les coefficients multiplicatifs $h_i$ sont réels et constants et connus du détecteur de symboles, mais le principe est applicable aux cas où ils sont complexes et variables. Pour les résultats présentés ci-après, les coefficients $h_i$ ont été fixés à :

$$h_0 = \sqrt{0,45}, \ h_1 = \sqrt{0,25}, \ h_2 = \sqrt{0,15}, \ h_3 = \sqrt{0,10}, \ h_4 = \sqrt{0,05}$$

et vérifient $\Sigma_{i=0 \text{ à } 4} \ h_i^2 = 1$. Le canal de transmission est également perturbé par un bruit additif blanc gaussien.

En sortie du canal, les échantillons reçus $R_n$ sont quantifiés sur 8 bits. Le détecteur de symboles et le décodeur de canal utilisent l'algorithme présenté dans le brevet FR-A-2 675 968. Le fonctionnement du codeur est également représenté par un treillis à 16 états. Les valeurs de coefficients $\gamma_1$ et $\gamma_2$ ont été déterminées de façon empirique.

Les résultats présentés utilisent 4 modules. Les courbes $C_1$ et $C_2$ représentent le taux d'erreur en sortie de la chaîne de transmission, respectivement sans et avec codage de canal, en l'absence d'interférence entre symboles : $C_3$ donne le taux d'erreur dans le cas classique où le détecteur de symboles fournit une décision binaire (décision ferme) et les courbes $C_{4i}$ montrent les résultats obtenus avec le dispositif proposé, après l'itération de rang i.

Ces courbes montrent donc que à un taux d'erreur de $10^{-5}$, l'utilisation d'un détecteur de symboles à sortie pondérée permet de gagner 1,6dB par rapport à un détecteur à décision ferme et les trois itérations supplémentaires apportent un gain supplémentaire de 3 dB environ. Lorsque le nombre d'itérations augmente, les performances se rapprochent de celles obtenues sur un canal gaussien codé.

**Revendications**

1. Dispositif de réception de signaux formés d'une série de symboles numériques correspondant au codage convolutif de données numériques source,
   **caractérisé en ce qu'**il comprend p modules (61 à 64) de détection et de décodage $M_1$ à $M_p$ en cascade, p étant supérieur ou égal à 2,
   chacun desdits modules $M_i$ comprenant :

   des moyens (41, 47, 48) de correction de l'interférence entre symboles, alimentés par une entrée de symbole $R_i$ et délivrant des symboles estimés $A_{i,1}$ à valeurs pondérées,
   des moyens (43) de décodage desdits symboles estimés $A_{i,1}$, effectuant des opérations symétriques audit codage convolutif et délivrant des symboles décodés $A_{i,2}$ à valeurs pondérées, et
   des moyens (44, 46) de calcul d'une information de correction $Z_{i+1}$ à partir dudit symbole estimé $A_{i,1}$ et dudit symbole décodé $A_{i,2}$,

   lesdits moyens (41) de correction de chacun desdits modules $M_i$, à l'exception du premier module $M_1$, tenant compte d'au moins une information de correction $Z_i$ déterminée par le module précédent $M_{i-1}$.

2. Dispositif selon la revendication 1, **caractérisé en ce que** chacun desdits modules $M_i$ présente deux entrées, une entrée de symbole $R_i$ et une entrée de correction $Z_i$, et trois sorties, une sortie de symbole $R_{i+1}$, une sortie de

correction $Z_{i+1}$ et une sortie de symbole décodé $D_{i+1}$,

l'entrée de symbole $R_i$ du module $M_i$ étant connectée à la sortie de symbole $R_i$ du module $M_{i-1}$, pour i supérieur à 1, et étant alimenté par les symboles reçus pour i égal à 1,

l'entrée de correction $Z_i$ du module $M_i$ étant connectée à la sortie de correction $Z_i$ du module $M_{i-1}$, pour i supérieur à 1, et étant alimenté par une valeur neutre, n'influant par sur la correction, pour i égal à 1,

la sortie de symbole $R_{i+1}$ du module $M_i$ étant égale à l'entrée de symbole $R_i$ dudit module $M_i$ retardée du temps de latence imposé par le module $M_i$,

la sortie de correction $Z_{i+1}$ délivrant ladite information de correction, et

la sortie de symbole décodé $D_{i+1}$ étant inutilisée pour les modules $M_1$ à $M_{p-1}$, et étant alimentée par le symbole décodé $A_{p,2}$ du module $M_p$ si le code mis en oeuvre est un code systématique, et par une valeur reconstituée en fonction du code mis en oeuvre sinon.

3. Dispositif selon l'une quelconque des revendications 1 et 2, **caractérisé en ce que** lesdits moyens (41) de correction de l'interférence entre symboles sont alimentés par une information de correction $Z_i$ représentative d'une différence (44) entre chaque symbole décodé $A_{i,2}$ et le symbole estimé $A_{i,1}$ correspondant.

4. Dispositif selon la revendication 3, **caractérisé en ce que** lesdits moyens de calcul de l'information de correction comprennent des moyens (46) de multiplication desdits symboles estimés $A_{i,1}$ par un coefficient pondérateur positif $\gamma_2$, délivrant des symboles pondérés, et des moyens (44) de soustraction calculant la différence entre chaque symbole décodé $A_{i,2}$ et le symbole pondéré correspondant, et délivrant ladite information de correction $Z_i$.

5. Dispositif selon l'une quelconque des revendications 1 à 4, **caractérisé en ce que** lesdits moyens (41, 47, 48) de correction de l'interférence entre symboles effectuent les opérations suivantes :

   - calcul (41) d'une valeur de correction $V_i = \gamma_1|Z_i|$, où $\gamma_1$ est un coefficient positif et où $|\ |$ représente l'opérateur valeur absolue ;
   - pour chaque branche du treillis correspondant audit code convolutif, détermination (41) d'un symbole détecté $A_{i,0}$, comprenant les étapes suivantes :

      - si le symbole affecté à ladite branche est de même signe que ladite information de correction $Z_i$, soustraction à la métrique associée à ladite branche de ladite valeur de correction $V_i$;
      - si le symbole affecté à ladite branche est de signe opposé à celui de ladite information de correction $Z_i$, addition à la métrique associée à ladite branche de ladite valeur de correction $V_i$ ;

   - soustraction (47) audit symbole détecté $A_{i,0}$ de la valeur $\gamma_1 Z_i$.

6. Dispositif selon la revendication 5, **caractérisé en ce que** ledit coefficient $\gamma_1$ dépend d'au moins une des informations appartenant au groupe comprenant :

   - le rapport signal à bruit ;
   - le numéro i du module considéré.

7. Dispositif selon l'une quelconque des revendications 1 à 6, appliqué à la réception de symboles soumis à un entrelacement à l'émission, **caractérisé en ce qu'**il comprend :

   - des moyens (42) de désentrelacement assurant l'opération symétrique dudit entrelacement, insérés entre lesdits moyens de correction et lesdits moyens de décodage ; et
   - des moyens (45) d'entrelacement assurant un entrelacement desdites informations de correction identique audit entrelacement à l'émission.

8. Module de détection et de décodage destiné à être mis en oeuvre dans un dispositif de réception de signaux formés d'une série de symboles numériques correspondant au codage convolutif de données numériques source, ledit dispositif comprenant au moins deux modules en cascade,

**caractérisé en ce qu'**il présente deux entrées, une entrée de symbole $R_i$ et une entrée de correction $Z_i$, et trois sorties, une sortie de symbole $R_{i+1}$, une sortie de correction $Z_{i+1}$ et une sortie de symbole décodé $D_{i+1}$,

et **en ce qu'**il comprend :

   des moyens (41, 47, 48) de correction de l'interférence entre symboles, alimentés par ladite entrée de symbole

$R_i$ et tenant compte de ladite entrée de correction $Z_i$, et délivrant des symboles estimés $A_{i,1}$,

des moyens (43) de décodage desdits symboles estimés $A_{i,1}$, effectuant des opérations symétriques audit codage convolutif et délivrant des symboles décodés $A_{i,2}$, et

des moyens (44, 46) de calcul d'une information de correction $Z_{i+1}$ à partir dudit symbole estimé $A_{i,1}$ et dudit symbole décodé $A_{i,2}$,

la sortie de symbole $R_{i+1}$ étant égale à 1' entrée de symbole $R_i$ retardée d'un temps de latence prédéfini,

la sortie de correction $Z_{i+1}$ délivrant ladite information de correction, et

la sortie de symbole décodé $D_{i+1}$ étant alimentée par ledit symbole décodé $A_{i,2}$, ou par une valeur reconstituée en fonction du code mis en oeuvre.

9. Procédé de réception de signaux formés d'une série de symboles numériques correspondant au codage convolutif de données numériques source,
**caractérisé en ce qu'**il comprend les étapes suivantes :

- alimentation (51) par les symboles reçus $R_i$ ;
- correction (521) de l'interférence entre symboles affectant chacun desdits symboles reçus à partir d'une information de correction $Z_i$, et délivrant des symboles estimés $A_{i,1}$ ;
- décodage (523) desdits symboles estimés $A_{i,1}$, effectuant des opérations symétriques audit codage convolutif et délivrant des symboles décodés $A_{i,2}$ ;
- calcul (524) de ladite information de correction $Z_i$, à partir et d'au moins un desdits symboles estimés $A_{i,1}$ et d'au moins un desdits symboles décodés $A_{i,2}$.

**Claims**

1. Device for the reception of signals formed by a series of digital symbols corresponding to the convolutive encoding of items of source digital data **characterised in that** it comprises p cascade-connected detection and decoding modules (61 to 64) $M_1$ to $M_p$, p being greater than or equal to 2, each of said modules $M_i$ including:

inter-symbol interference correction means (41, 47, 48) supplied by a symbol input $R_i$ and delivering estimated symbols $A_{1,1}$ with weighted values,

means (43) for the decoding of said estimated symbols $A_{i,1}$ performing operations symmetrical to said convolutive encoding and delivering decoded symbols $A_{i,2}$ with weighted values, and

means (44, 46) for the computation of an item of correction information $Z_{1+1}$ from said estimated symbol $A_{i,1}$ and said decoded symbol $A_{1,2}$,

said means (41) for the correction of each of said modules $M_i$, except for the first module $M_1$, taking account of at least one item of correction information $Z_i$ determined by the previous module $M_{i-1}$.

2. Device according to claim 1, **characterised in that** each of said modules $M_i$ has two inputs, one symbol input $R_i$ and one correction input $Z_i$ and three outputs, one symbol output $R_{i+1}$, one correction output $Z_{i+1}$ and one decoded symbol output $D_{i+1}$,

the symbol input $R_i$ of the module $M_i$ being connected to the symbol output $R_i$ of the module $M_{i-1}$ for i greater than 1 and being supplied with the symbols received for 1 equal to 1,

the correction input $Z_i$ of the module $M_i$ being connected to the correction output $Z_i$ of the module $M_{i-1}$ for i greater than 1 and being supplied with a neutral value that does not affect the correction for i equal to 1,

the symbol output $R_{i+1}$ of the module $M_i$ being equal to the symbol input $R_i$ of said module $M_i$ delayed by the latency time dictated by the module $M_i$,

the correction output $Z_{i+1}$ delivering said correction information, and

the decoded symbol output $D_{i+1}$ being unused for the modules $M_1$ to $M_{p-1}$ and being supplied with the decoded symbol $A_{p,2}$ of the module $M_p$ if the code implemented is a systematic code and, if not, with a corresponding reconstituted value.

3. Device according to any one of the claims 1 and 2, **characterised in that** said means (41) for the correction of the inter-symbol interference are supplied with an item of correction information $Z_i$ representing a difference (44) between each decoded symbol $A_{1,2}$ and the corresponding estimated symbol $A_{i,1}$.

4. Device according to claim 3, **characterised in that** said means to compute the item of correction information comprise means (46) for the multiplication of said estimation symbols $A_{i,1}$ by a positive weighting coefficient $\gamma_2$ delivering weighted symbols, and subtraction means (44) computing the difference between each decoded symbol $A_{i,2}$ and the corresponding weighted symbol and delivering said items of correction information $Z_i$.

5. Device according to any of the claims 1 to 4, **characterised in that** said means (41, 47, 48) for the correction of inter-symbol interference perform the following operations:

   - the computation (41) of a correction value $V_i = \gamma_1 |Z_i|$, where $\gamma_1$ is a positive coefficient and where $||$ represents the absolute value operator;

   - for each arm of the lattice corresponding to said convolutive code, the determining (41) of a detected symbol $A_{i,0}$, comprising the following steps:

   - if the symbol assigned to said branch has the same sign as said item of correction information $Z_i$, the subtraction, from the metric associated with said arm, of said correction value $V_i$;

   - if the symbol assigned to said arm has a sign opposite that of said item of correction information $Z_i$, the addition, to the metric associated with said arm, of said correction value $V_i$;

   - the subtraction (47), from said detected symbol $A_{i,0}$, of the value $\gamma_i Z_i$.

6. Device according to claim 5, **characterised in that** said coefficient $\gamma_1$ depends on at least one of the items of information belonging to the group comprising:

   - the signal-to-noise ratio;
   - the number i of the module considered.

7. Device according to any of claims 1 to 6, applied to the reception of symbols subjected to an interleaving operation at transmission, **characterised in that** it comprises:

   - de-interleaving means (42) providing for the symmetrical operation of said interleaving, inserted between said correction means and said decoding means; and

   - interleaving means (45) providing for an interleaving of said items of correction information that is identical to said interleaving at transmission.

8. Detection and decoding module designed to be implemented in a device for the reception of signals formed by a series of digital symbols corresponding to the convolutive encoding of items of source digital data, said device comprising at least two cascade-connected modules, **characterised in that** it has two inputs, one symbol input $R_i$ and one correction input $Z_i$, and three outputs, one symbol output $R_{i+1}$, one correction output $Z_{i+1}$ and one decoded symbol output $D_{i+1}$, and that it comprises:

   means (41, 47, 48) for the correction of inter-symbol interference, supplied by said symbol input $R_i$ and taking account of said correction input $Z_i$ and delivering estimated symbols $A_{i,1}$,

   means (43) for the decoding of said estimated symbols $A_{i,1}$, performing operations symmetrical to said convolutive encoding and delivering decoded symbols $A_{i,2}$, and

   means (44, 46) for the computation of an item of correction information $Z_{i+1}$ from said estimated symbol $A_{i,1}$ and said symbol decoded symbol $A_{i,2}$,

the symbol output $R_{i+1}$ being equal to the symbol input $R_i$ delayed by a predefined latency time,

the correction output $Z_{i+1}$ delivering said correction information, and

the decoded symbol output $D_{i+1}$ being supplied with said decoded symbol $A_{i,2}$ or with a value reconstituted as a function of the code implemented.

**9.** Method for the reception of signals formed by a series of digital symbols corresponding to the convolutive encoding of items of source digital data comprising the following steps:

- supplying (51) with received symbols $R_{i+}$;

- correction (521) of inter-symbol intereference affecting each of said received symbols, by means of an item of correction information $Z_i$, and the delivery of estimated symbols $A_{i,1}$;

- the decoding (523) of said estimated $A_{i,1}$ entailing operations symmetrical to said convolutive encoding, and delivery of decoded symbols $A_{i,2}$;

- the computation (524) of said items of correction information $Z_i$ from at least one of said estimated symbols $A_{i,1}$ and at least one of said decoded symbols $A_{i,2}$.

**Patentansprüche**

**1.** Empfangsvorrichtung für aus einer Reihe digitaler Symbole gebildeter Signale, entsprechend der faltenden Kodierung von digitalen Quellendaten,
**dadurch gekennzeichnet, dass** sie p Module (61 bis 64) zur Erfassung und zum Dekodieren, $M_1$ bis $M_p$ in Kaskade umfasst, wobei p größer oder gleich 2 ist,
wobei jedes der Module $M_i$ folgendes umfasst:

Korrekturmittel (41, 47, 48) zur Korrektur der Interferenz zwischen Symbolen, gespeist durch einen Symboleingang $R_i$, die geschätzte Symbole $A_{i,1}$ mit gewichteten Werten liefert,
Dekodiermittel (43) zur Dekodierung dieser geschätzten Symbole $A_{i,1}$, die Operationen ausführen, welche zur faltenden Kodierung symmetrisch sind und dekodierte Symbole $A_{i,2}$ mit gewichteten Werten liefern, und
Mittel (44, 46) zum Berechnen einer Korrekturinformation $Z_{i+1}$, ausgehend vom geschätzten Symbol $A_{i,1}$ und des dekodierten Symbols $A_{i,2}$,

wobei die Korrekturmittel (41) eines jeden der Module $M_i$, mit Ausnahme des ersten Moduls $M_1$, zumindest eine vom vorhergehenden Modul $M_{i-1}$ definierte Korrekturinformation $Z_i$ berücksichtigen.

**2.** Vorrichtung nach Anspruch 1, **dadurch gekennzeichnet, dass** jedes der Module $M_i$ zwei Eingänge, einen Symboleingang $R_i$ und einen Korrektureingang $Z_i$ sowie drei Ausgänge aufweist, einen Symbolausgang $R_{i+1}$, einen Korrekturausgang $Z_{i+1}$ und einen Ausgang für dekodierte Symbole $D_{i+1}$,
wobei der Symboleingang $R_i$ des Moduls $M_i$ mit dem Symbolausgang $R_i$ des Moduls $M_{i-1}$ verbunden ist, wenn i größer 1 ist und von den empfangenen Symbolen gespeist wird, wenn i gleich 1 ist,
wobei der Korrektureingang $Z_i$ des Moduls $M_i$ mit dem Korrekturausgang $Z_i$ des Moduls $M_{i-1}$ verbunden ist, wenn i größer 1 ist und durch einen neutralen Wert gespeist wird, der keinen Einfluss auf die Korrektur hat, wenn i gleich 1 ist,
wobei der Symbolausgang $R_{i+1}$ des Moduls $M_i$ dem Symboleingang $R_i$ dieses Moduls $M_i$ gleicht, verzögert durch die vom Modul $M_i$ auferlegte Latenzzeit,
wobei der Korrekturausgang $Z_{i+1}$ die Korrekturinformation liefert und,
wobei der Ausgang für dekodierte Symbole $D_{i+1}$ von den Modulen $M_1$ bis $M_{p-1}$ nicht genutzt wird und vom dekodierten Symbol $A_{p,2}$ des Moduls $M_p$ gespeist wird, wenn es sich beim verwendeten Code um einen systematischen Code handelt und andernfalls von einem als Funktion des verwendeten Codes rekonstruierten Wert.

**3.** Vorrichtung nach einem der Ansprüche 1 oder 2, **dadurch gekennzeichnet, dass** die Korrekturmittel (41) der Interferenz zwischen Symbolen von einer Korrekturinformation $Z_i$ gespeist werden, die für eine Differenz (44) zwischen jedem dekodierten Symbol $A_{i,2}$ und dem entsprechenden geschätzten Symbol $A_{i,1}$ repräsentativ ist.

**4.** Vorrichtung nach Anspruch 3, **dadurch gekennzeichnet, dass** die Berechnungsmittel für die Korrekturinformation Mittel (46) zum Multiplizieren dieser geschätzten Symbole $A_{i,1}$ mit einem positiven Wichtungskoeffizienten $\gamma_2$, welcher gewichtete Symbole liefert sowie Mittel (44) zum Subtrahieren umfassen, welche die Differenz zwischen einem jeden dekodierten Symbol $A_{i,2}$ und dem entsprechenden gewichteten Symbol, und welche die Korrekturinformation $Z_i$ liefern.

5.  Vorrichtung nach einem der Ansprüche 1 bis 4, **dadurch gekennzeichnet, dass** die Korrekturmittel (41, 47, 48) der Interferenz zwischen den Symbolen die folgenden Operationen ausführen:

    - Berechnen (41) eines Korrekturwertes $V_i = \gamma_1 |Z_i|$, wobei $\gamma_1$ ein positiver Koeffizient ist und wobei | | den Absolutwert bedeutet,
    - für jeden Zweig des dem faltenden Code entsprechenden Gitters, Feststellung (41) eines erfassten Symbols $A_{i,0}$, das die folgenden Schritte umfasst:

        - wenn das dem benannten Zweig entsprechende Symbol dasselbe Vorzeichen als die Korrekturinformation $Z_i$ hat, Subtrahieren des Korrekturwertes $V_i$ von der diesem Zweig zugeordneten Metrik,
        - wenn das dem benannten Zweig entsprechende Symbol das entgegengesetzte Vorzeichen als das der Korrekturinformation $Z_i$ hat, Addieren des Korrekturwertes $V_i$ zu der diesem Zweig zugeordneten Metrik,

    - Subtrahieren (47) des Wertes $\gamma_1 Z_i$ vom erfassten Symbol $A_{i,0}$.

6.  Vorrichtung nach Anspruch 5, **dadurch gekennzeichnet, dass** der Koeffizient $\gamma_1$ von mindestens einer der Informationen abhängig ist, die der Gruppe zugehört, welche folgendes umfasst:

    - das Signal-Rausch-Verhältnis,
    - die Nummer i des betrachteten Moduls.

7.  Vorrichtung nach einem der Ansprüche 1 bis 6, eingesetzt für den Empfang von Symbolen, die beim Senden verschachtelt werden, **dadurch gekennzeichnet, dass** sie folgendes umfasst:

    - Entschachtelungsmittel (42), welche die symmetrische Operation zur Entschachtelung gewährleisten, eingefügt zwischen den Korrekturmitteln und den Dekodierungsmitteln und,
    - Verschachtelungsmittel (45), die eine Verschachtelung dieser Korrekturinformationen sicherstellen, welche der Verschachtelung beim Senden identisch ist.

8.  Erfassungs- und Kodiermodul zur Verwendung in einer Empfangsvorrichtung für aus einer Reihe digitaler Symbole gebildeter Signale, entsprechend der faltenden Kodierung von digitalen Quellendaten, wobei die Vorrichtung mindestens zwei Module in Kaskade umfasst,
    **dadurch gekennzeichnet, dass** es zwei Eingänge, einen Symboleingang $R_i$ und einen Korrektureingang $Z_i$ sowie drei Ausgänge aufweist, einen Symbolausgang $R_{i+1}$, einen Korrekturausgang $Z_{i+1}$ und einen Ausgang für dekodierte Symbole $D_{i+1}$ und,
    dadurch, dass es folgendes umfasst:

    Korrekturmittel (41, 47, 48) zur Korrektur der Interferenz zwischen Symbolen, gespeist durch den Symboleingang $R_i$ und den Korrektureingang $Z_i$ und welche die geschätzten Symbole $A_{i,1}$ liefern,
    Dekodiermittel (43) der geschätzten Symbole $A_{i,1}$, die Operationen ausführen, welche zur faltenden Kodierung symmetrisch sind und dekodierte Symbole $A_{i,2}$ mit gewichteten Werten liefern und
    Berechnungsmittel (44, 46) für eine Korrekturinformation $Z_{i+1}$, ausgehend vom geschätzten Symbol $A_{i,1}$ und vom dekodierten Symbol $A_{i,2}$,

    wobei der Symbolausgang $R_{i+1}$ dem Symboleingang $R_i$ gleicht, verzögert durch eine im voraus definierte Latenzzeit,
    wobei der Korrekturausgang $Z_{i+1}$ die Korrekturinformation liefert, und
    wobei der Ausgang für dekodierte Symbole $D_{i+1}$ vom dekodierten Symbol $A_{i,2}$ oder von einem als Funktion des angewandten Codes wiederhergestellten Wert gespeist wird.

9.  Verfahren zum Empfangen von Signalen, die aus einer Reihe digitaler Symbole gebildet werden, entsprechend der faltenden Kodierung von digitalen Quellendaten,
    **dadurch gekennzeichnet, dass** es die folgenden Schritte umfasst:

- Speisung (51) durch die empfangenen Symbole $R_i$;
- Korrektur (521) der Interferenz zwischen den Symbolen, die ausgehend von einer Korrekturinformation $Z_i$ ein jedes der empfangenen Symbole betreffen und geschätzte Symbole $A_{i,1}$ liefern;
- Dekodierung (523) der geschätzten Symbole $A_{i,1}$, die Operationen ausführen, welche zur faltenden Kodierung symmetrisch sind und dekodierte Symbole $A_{i,2}$ liefern;
- Berechnung (524) der Korrekturinformation $Z_i$, ausgehend von mindesten einem der geschätzten Symbole $A_{i,1}$ und mindestens einem der dekodierten Symbole $A_{i,2}$.

Fig. 1

Fig. 2

Fig. 3

Fig. 4

Fig. 6

Fig. 5

**Fig. 7**

**Fig. 8**